# EUROPEAN PATENT APPLICATION

(11) **EP 4 383 969 A1**
(43) Date of publication of application: **12.06.2024**
(21) Application number: 23168059.6
(22) Date of filing: 14.04.2023
(51) Int. Cl.: H05K 7/20

(54) **IMMERSION COOLING DEVICE, ACTIVE HEAT DISSIPATION MODULE AND ACTIVE FLOW-GUIDING MODULE**

(30) Priority: 09.12.2022 TW 111147321
(71) Applicant: Wistron Corporation, New Taipei City 22181 (TW)
(72) Inventor: CHU, Shao-Jen, 22181 New Taipei City (TW); WU, Yu Chuan, 22181 New Taipei City (TW); CHEN, Hua, 22181 New Taipei City (TW); LIANG, Chuan-Yi, 22181 New Taipei City (TW)
(74) Representative: Becker, Eberhard

(57) **Abstract**

An immersion cooling device (100) includes a housing, at least one heating component (120), at least one heat dissipation component (142), and at least one fluid-driving unit (1442). The housing (105) includes a tank (110) and at least one cover (1441) and has a containing structure (S1). The heating component (120) is located in the containing structure (S1). The immersion cooling device is adapted to cool the heating component (120) in a single phase. The heat dissipation component (142) is disposed on the heating component (120). The cover (1441) has a flow-guiding structure (S2) and covers the heat dissipation component (142), such that the heat dissipation component (142) is located in the flow-guiding structure (S2). The flow-guiding structure (S2) communicates between the fluid-driving unit (1442) and the containing structure (S1). Additionally, an active heat dissipation module (140) and an active flow-guiding module (144) are also provided.

## Description

### BACKGROUND

### Technical Field

The disclosure relates to a cooling device, a heat dissipation module, and a flow-guiding module. Particularly, the disclosure relates to an immersion cooling device, an active heat dissipation module, and an active flow-guiding module.

### Description of Related Art

Liquid cooling heat dissipation is generally divided into direct contact liquid cooling and immersion cooling. Immersion liquid cooling may further be divided into two modes, i.e., single-phase and two-phase. The structure of a single-phase immersion liquid cooling device is relatively simple without a fan, achieving low noise, low power consumption, and efficient use. In addition, the overall system is stable and reliable since the cooling liquid does not undergo phase change and there is no need for airtightness and pressure control.

However, viscosity of the cooling liquid used in the general single-phase immersion liquid cooling device is relatively high, and the cooling liquid is unlikely to be driven for convection. As a result, in the internal flow field of the device, the flow velocity is slow and the flow amount is insufficient, which is likely to cause overheating of the high-wattage electronic components to be cooled. Alternatively, the single-phase immersion liquid cooling device needs to be used with a large-size heat dissipation component (e.g., a large-size heat dissipation fin) to compensate for the insufficient flow velocity and flow amount. As such, the internal space of the device is occupied instead, and the number of containable electronic components to be cooled is reduced.

### SUMMARY

The disclosure provides an immersion cooling device, an active heat dissipation module, and an active flow-guiding module, which may effectively improve cooling of a heating component.

An immersion cooling device of an embodiment of the disclosure includes a housing, at least one heating component, at least one heat dissipation component, and at least one fluid-driving unit. The housing includes a tank and at least one cover and has a containing structure. The heating component is located in the containing structure. The immersion cooling device is adapted to cool the heating component in a single phase. The heat dissipation component is disposed on the heating component. The cover has a flow-guiding structure and covers the heat dissipation component, such that the heat dissipation component is located in the flow-guiding structure. The fluid-driving unit is connected to the cover. The flow-guiding structure communicates between the fluid-driving unit and the containing structure.

In an embodiment of the disclosure, the at least one cover includes a top wall and two sidewalls, and the two sidewalls are respectively connected to two opposite edges of the top wall.

In an embodiment of the disclosure, the immersion cooling device further includes at least one circuit board. The at least one heating component is disposed on the at least one circuit board, and at least one of the at least one cover and the at least one heat dissipation component is assembled on the at least one circuit board.

In an embodiment of the disclosure, the at least one cover is assembled on the at least one heat dissipation component.

In an embodiment of the disclosure, the at least one cover has a connecting end and an opening end opposite to each other. The connecting end is connected to the at least one fluid-driving unit. The flow-guiding structure communicates with the containing structure through the opening end.

In an embodiment of the disclosure, the at least one cover has at least one tapered guide surface, and the at least one tapered guide surface is located between the at least one fluid-driving unit and the at least one heat dissipation component.

In an embodiment of the disclosure, the at least one tapered guide surface includes two tapered guide surfaces. The two tapered guide surfaces are opposite to each other. A distance between the two tapered guide surfaces gradually increases from the at least one fluid-driving unit to the at least one heat dissipation component.

In an embodiment of the disclosure, there is a gap between the at least one heat dissipation component and the at least one fluid-driving unit.

In an embodiment of the disclosure, the at least one heat dissipation component is a heat dissipation fin group.

In an embodiment of the disclosure, the containing structure is adapted to contain a heat dissipation medium. The at least one fluid-driving unit is adapted to drive the heat dissipation medium to flow through the flow-guiding structure.

An active heat dissipation module of an embodiment of the disclosure includes a heat dissipation component, a cover, and a fluid-driving unit. The cover has a flow-guiding structure. The cover covers the heat dissipation component, such that the heat dissipation component is located in the flow-guiding structure. The fluid-driving unit is connected to the cover. The flow-guiding structure communicates with the fluid-driving unit.

In an embodiment of the disclosure, the cover includes a top wall and two sidewalls, and the two sidewalls are respectively connected to two opposite edges of the top wall.

In an embodiment of the disclosure, the cover is assembled on the heat dissipation component.

In an embodiment of the disclosure, the cover has a connecting end and an opening end opposite to each other, and the connecting end is connected to the fluid-driving unit.

In an embodiment of the disclosure, the cover has at least one tapered guide surface, and the at least one tapered guide surface is located between the fluid-driving unit and the heat dissipation component.

In an embodiment of the disclosure, the at least one tapered guide surface includes two tapered guide surfaces. The two tapered guide surfaces are opposite to each other. A distance between the two tapered guide surfaces gradually increases from the fluid-driving unit to the heat dissipation component.

In an embodiment of the disclosure, there is a gap between the heat dissipation component and the fluid-driving unit.

In an embodiment of the disclosure, the heat dissipation component is a heat dissipation fin group.

An active flow-guiding module of an embodiment of the disclosure includes a cover and a fluid-driving unit. The cover has a flow-guiding structure. The fluid-driving unit is connected to the cover. The flow-guiding structure communicates with the fluid-driving unit.

In an embodiment of the disclosure, the cover includes a top wall and two sidewalls, and the two sidewalls are respectively connected to two opposite edges of the top wall.

In an embodiment of the disclosure, the cover has a connecting end and an opening end opposite to each other, and the connecting end is connected to the fluid-driving unit.

In an embodiment of the disclosure, the cover has at least one tapered guide surface, and the at least one tapered guide surface is adjacent to the fluid-driving unit.

In an embodiment of the disclosure, the at least one tapered guide surface includes two tapered guide surfaces. The two tapered guide surfaces are opposite to each other. A distance between the two tapered guide surfaces gradually increases along a direction away from the fluid-driving unit.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic view of an immersion cooling device according to an embodiment of the disclosure.
FIG. 2A is a schematic view of the active heat dissipation module of FIG. 1.
FIG. 2B is a schematic view in another perspective of the active heat dissipation module of FIG. 1.
FIG. 3A is a schematic partial view of the active heat dissipation module of FIG. 1 assembled on a circuit board.
FIG. 3B is an exploded view of FIG. 3A.
FIG. 4 is a schematic view of an immersion cooling device according to another embodiment of the disclosure.
FIG. 5 is a schematic view of an active heat dissipation module of FIG. 4.

### DESCRIPTION OF THE EMBODIMENTS

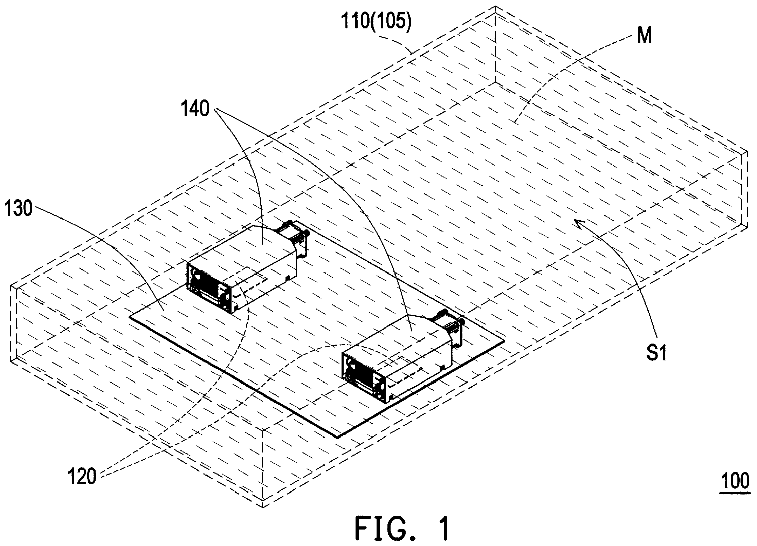

FIG. 1 is a schematic view of an immersion cooling device according to an embodiment of the disclosure. FIG. 1 shows a heating component with dashed lines. With reference to FIG. 1, in this embodiment, an immersion cooling device 100 includes a housing 105, at least one heating component 120, and at least one active heat dissipation module 140. Two heating components 120 and two active heat dissipation modules 140 are shown, but the numbers thereof are not limited thereto. The housing 105 includes a tank 110 and a cover 1441. The tank 110 has a containing structure S1 adapted to contain a heat dissipation medium M, for example, a cooling liquid. The immersion cooling device 100 is a single-phase cooling device. In other words, the heat dissipation medium M remains in a liquid state during the heat exchange process. The heating component 120 is located in the containing structure S1 and may, for example, be disposed on at least one circuit board 130 (one circuit board is shown). For example, the heating component 120 is a chipset of a server immersed in the heat dissipation medium M to transfer heat generated by the heating component 120 to the heat dissipation medium M to cool the heating component 120. The single-phase immersion cooling device 100 is a known technology, and the detailed functioning manner thereof will not be repeatedly described here.

In the immersion cooling device 100 of this embodiment, by the active heat dissipation module 140 disposed on the circuit board 130 and aligned the heating component 120, it is possible to effectively increase the flow of the heat dissipation medium M in the containing structure S1, and particularly to increase the flow amount and the flow velocity of the heat dissipation medium M near the heating component 120. As a result, heat dissipation for the heating component 120 is improved. This will be described in detail below.

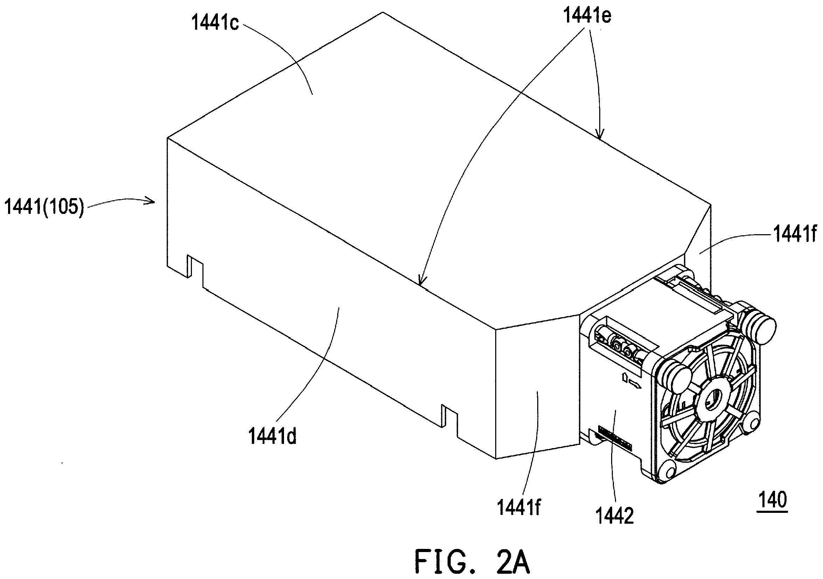

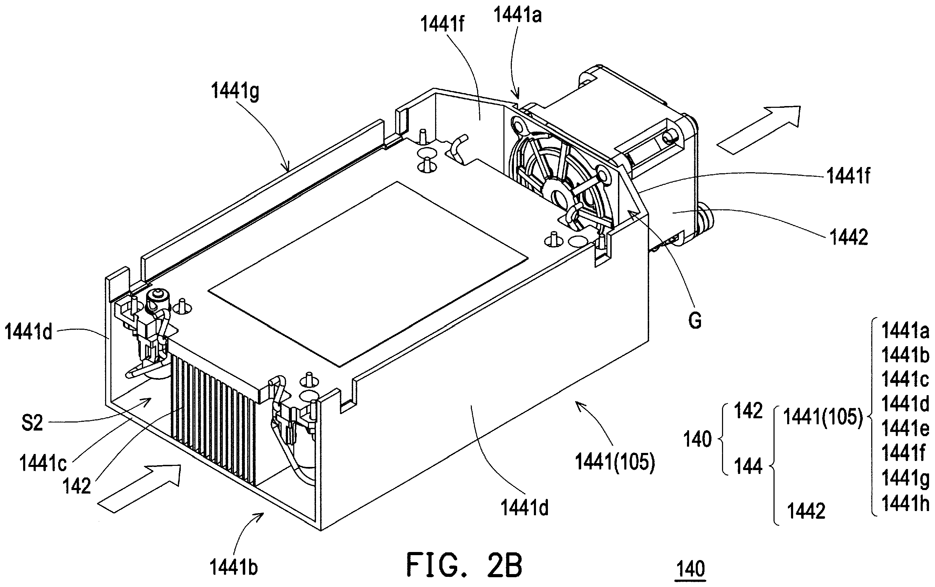

FIG. 2A is a schematic view of the active heat dissipation module of FIG. 1. FIG. 2B is a schematic view in another perspective of the active heat dissipation module of FIG. 1. FIG. 2B also schematically shows the flow direction of the heat dissipation medium with bold arrows. With reference to FIG. 2A and FIG. 2B, specifically, in this embodiment, the active heat dissipation module 140 includes a heat dissipation component 142 (FIG. 2B) and an active flow-guiding module 144 (FIG. 2B). The active flow-guiding module 144 includes a cover 1441 and a fluid-driving unit 1442. For example, the heat dissipation component 142 is a heat dissipation fin group disposed on the heating component 120 (FIG. 1), and may exchange heat with the heating component 120 to transfer heat energy generated during operation of the heating component 120 to the heat dissipation component 142, but the form of the heat dissipation component 142 is not limited thereto. The cover 1441 has a flow-guiding structure S2 (FIG. 2B). The heat dissipation component 142 is covered by the cover 1441, such that the heat dissipation component 142 is located in the flow-guiding structure S2. The fluid-driving unit 1442 is connected to the cover 1441 by locking or engaging, for example, such that the flow-guiding structure S2 communicates between the fluid-driving unit 1442 and the containing structure S1 (FIG. 1). The fluid-driving unit 1442 is a pump, a pump motor, a fan, a small-size propeller, a wave maker, or a water jet propulsor, for example, and is adapted to drive the heat dissipation medium M to flow through the flow-guiding structure S2, but the form of the fluid-driving unit 1442 is not limited thereto.

In this embodiment, the cover 1441 has a connecting end 1441a and an opening end 1441b. The connecting end 1441a is connected to the fluid-driving unit 1442. The flow-guiding structure S2 communicates with the containing structure S1 through the opening end 1441b. The fluid-driving unit 1442 may drive the heat dissipation medium M (FIG. 1) to flow from the opening end 1441b through the containing structure S1, and then flow out of the cover 1441 from the connecting end 1441a. In other words, the flow direction of the heat dissipation medium M is from the lower left (i.e., the upstream end) to the upper right (i.e., the downstream end) in FIG. 2B. Nonetheless, the fluid-driving unit 1442 may also be designed to drive the heat dissipation medium M in a flow direction opposite to the flow direction indicated in FIG. 2B, that is, flowing from the upper right to the lower left in FIG. 2B, and the disclosure is not limited thereto.

The cover 1441 includes a top wall 1441c and two sidewalls 1441d. The projection area of the heat dissipation component 142 on the plane where the top wall 1441c is located does not extend beyond the top wall 1441c, such that the cover 1441 completely enhances efficiency of the flow field where the heat dissipation component 142 is located. The two sidewalls 1441d are respectively connected to two opposite edges 1441e of the top wall 1441c, such that the heat dissipation component 142 is surrounded by the top wall 1441c and the two sidewalls 1441d. In addition, the cover 1441 further has a bottom end 1441g opposite to the top wall 1441c. The bottom end 1441g communicates with the containing structure S1 (FIG. 1), which facilitates disposing the heat dissipation component 142 on the circuit board 130 via the bottom end 1441g.

Further, when the fluid-driving unit 1442 starts, the heat dissipation medium M outside the cover 1441 is driven to flow from the opening end 1441b into the flow-guiding structure S2. The heat dissipation medium M entering the flow-guiding structure S2 may flow through the heat dissipation component 142 and exchange heat with the heat dissipation component 142 to transfer heat energy of the heat dissipation component 142 to the heat dissipation medium M. Then, the heat dissipation medium M is discharged from the connecting end 1441a through the fluid-driving unit 1442. In other words, in this embodiment, the active heat dissipation module 140 drives the flow of the heat dissipation medium M by the fluid-driving unit 1442, and with the flow guiding of the cover 1441, may mitigate the adversely affected flow of the heat dissipation medium M due to high viscosity, increasing the flow amount of the heat dissipation medium M. In this embodiment, for example, the immersion cooling device 100 may increase the flow amount of the heat dissipation medium M from 0.54 liters per minute (LPM) to 1 LPM, decreasing the temperature of the heating component 120 by up to 7°C or more. For example, if the flow amount of the heat dissipation medium M is further increased to 5 LPM, the temperature of the heating component 120 may be lowered by up to 15°C or more, improving cooling on the heating component 120.

It is worth noting that, in this embodiment, the cover 1441 further includes at least one tapered guide surface 1441f. The tapered guide surface 1441f is connected to the top wall 1441c, the sidewalls 1441d, and the fluid-driving unit 1442, and is located between the fluid-driving unit 1442 and the heat dissipation component 142. There is a gap G between the heat dissipation component 142 and the fluid-driving unit 1442 to prevent reduction in the fluid-driving force of the fluid-driving unit 1442 due to an excessively close distance of the fluid-driving unit 1442 to the heat dissipation component 142. In this embodiment, two tapered guide surfaces 1441f opposite to each other are shown, and a distance between the two tapered guide surfaces 1441f gradually increases from the fluid-driving unit 1442 to the heat dissipation component 142. In other words, when the heat dissipation medium M flows from the heat dissipation component 142 to the fluid-driving unit 1442, the flow channel space between the two tapered guide surfaces 1441f is gradually narrowed, resulting in an increase in the flow velocity of the heat dissipation medium M and an increase in the heat exchange efficiency in the cover 1441, improving heat dissipation by the active heat dissipation module 140.

In addition, in this embodiment, since the cover 1441 achieves relatively effective flow-guiding, it is not required to add baffles in the tank 110 to guide the heat dissipation medium M to the target heat dissipation component, which not only saves the number or size of the materials of baffles, but also reduces the impedance of the overall flow field, helping further increase the flow amount of the heat dissipation medium M.

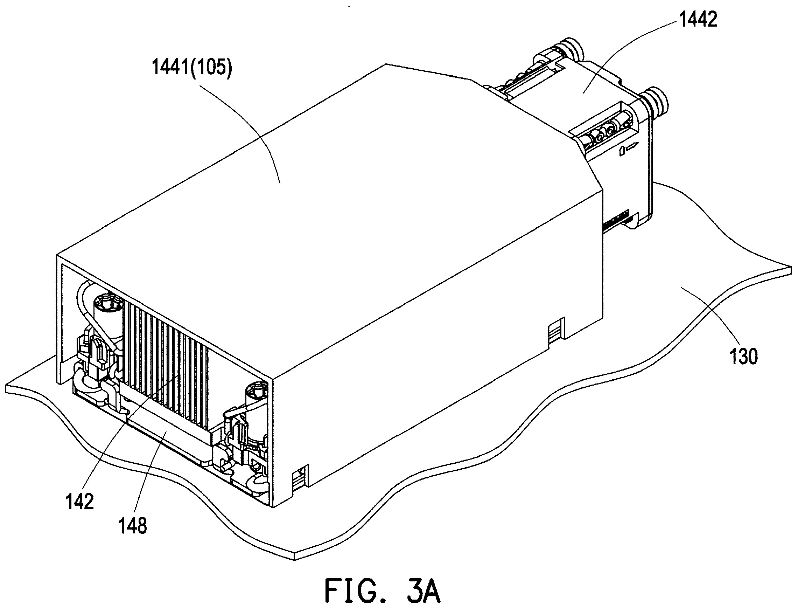

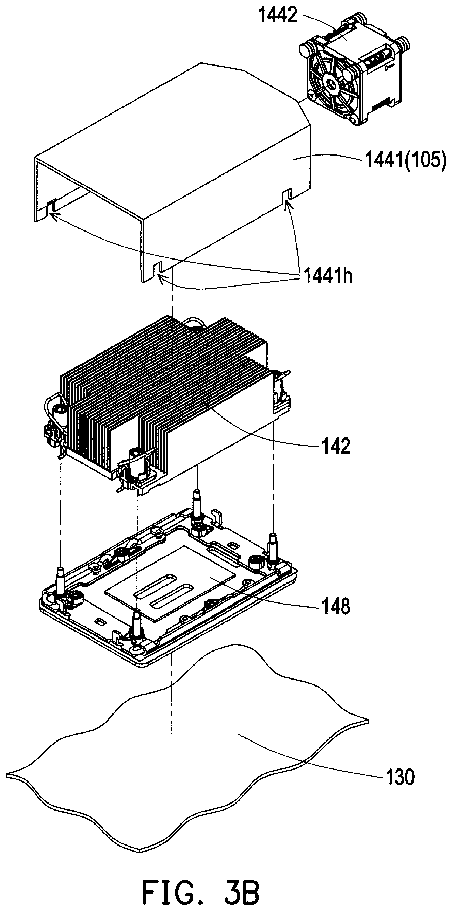

**FIG.** 3A is a schematic partial view of the active heat dissipation module of FIG. 1 assembled on a circuit board. FIG. 3B is an exploded view of FIG. 3A. With reference to FIG. 3A and FIG. 3B, in this embodiment, the active heat dissipation module 140 may be assembled on the circuit board 130 through at least one of the cover 1441 and the heat dissipation component 142. For example, the cover 1441 may be assembled with the fluid-driving unit 1442. The heat dissipation component 142 may be disposed on the circuit board 130 by an assembling element 148. Lastly, the cover 1441 is assembled on the heat dissipation component 142 or engaged on the fixing part (not shown) of the circuit board 130 through notches 1441h (FIG. 3B) of the cover 1441. Alternatively, the cover 1441 may first be assembled with the heat dissipation component 142 and the fluid-driving unit 1442, and then assembled on the circuit board 130 lastly. In other words, the heat dissipation component 142 may be an existing component on the circuit board 130, or may be integrated into the active heat dissipation module 140 and assembled on the circuit board 130 together. Nonetheless, the assembly of the active heat dissipation module 140 and the circuit board 130 is not limited thereto.

In addition, the components of the active heat dissipation module 140 may be assembled or fixed through screws, buckles, or clamp structures. The active heat dissipation module 140 may also be assembled on the circuit board 130 through screws, buckles, or clamp structures. The assembly or fixing of the components above is not limited by the disclosure, and may be adjusted depending on the actual design requirements.

In this embodiment, with the relatively simple structure of the active heat dissipation module 140, by the heat dissipation component 142 combined with the fluid-driving unit 1442, it is possible to directly dissipate heat from the heating component 120 with relatively high power and relatively high heat dissipation requirements without the need for changing the design of the overall flow field and adding baffles to guide the fluid toward the target heating component. In addition, the fluid-driving unit 1442 may adopt a common fan structure, and is thus compatible with the general immersion liquid cooling system without the need for modifying the circuit design. As a result, in this embodiment, the active heat dissipation module 140 is adapted for any immersion liquid cooling system, and is relatively flexible and convenient in application.

In addition, in this embodiment, the fluid-driving unit 1442 may forcibly drive the heat dissipation medium M to flow, improve the fluidity of the overall flow field, and may also help dissipate heat from other components with relatively low power, so relatively effective cooling can be achieved without increasing the size of the heat dissipation component 142. In this way, not only the design space in the tank 110 is saved, but the number of heating components 120 can also be increased. For a tank 110 with the same volume, the immersion cooling device 100 of this embodiment realizes relatively great heat dissipation capability, and may support a heating component 120 with a relatively high power or cause the heating component 120 to operate at a relatively high power, which is beneficial to the performance expansion of an electronic device.

In addition, if other relatively low-power components have relatively high heat dissipation requirements, the active heat dissipation module 140 may be combined with appropriate baffle design to increase the flow amount through these components and improve the cooling performance. If other relatively low-power components have relatively low heat dissipation requirements, cooling may be achieved by natural convection without the need for additional baffles, which is beneficial to further saving the materials and space.

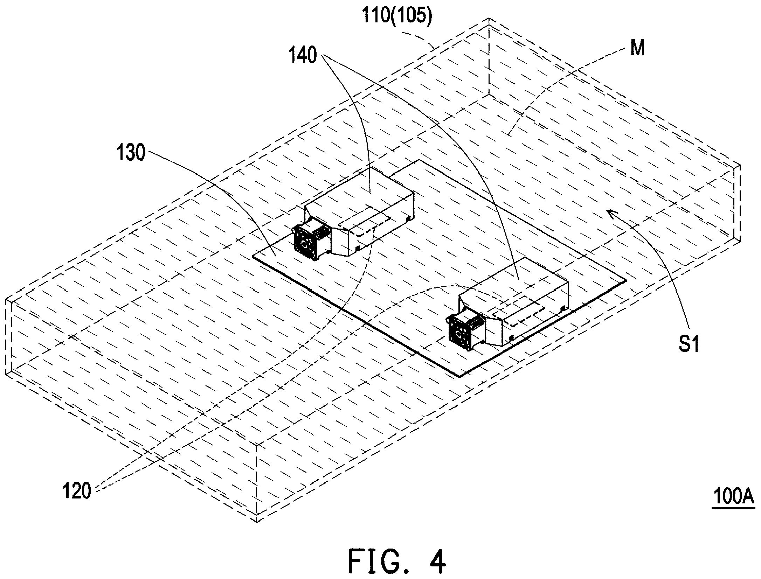

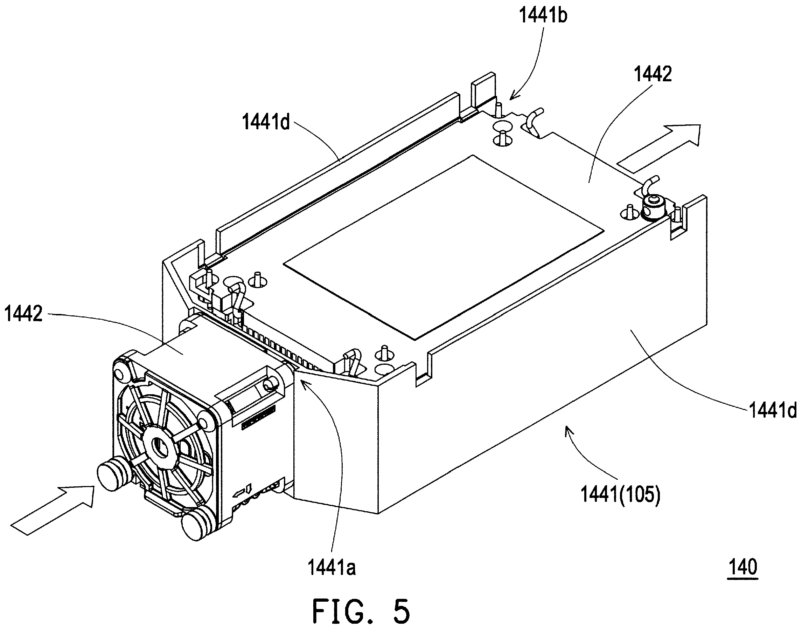

FIG. 4 is a schematic view of an immersion cooling device according to another embodiment of the disclosure, showing a heating component with dashed lines. FIG. 5 is a schematic view of an active heat dissipation module of FIG. 4. FIG. 5 also schematically shows the flow direction of the heat dissipation medium with bold arrows. With reference to FIG. 4 and

FIG. 5, the difference between the embodiment shown in FIG. 4 and the embodiment shown in FIG. 1 is that the arrangement direction of the active heat dissipation module 140 in an immersion cooling device 100A of FIG. 4 is opposite to the arrangement direction of the active heat dissipation module 140 of FIG. 1.

Further, in this embodiment, the fluid-driving unit 1442 may drive the heat dissipation medium M to flow from the connecting end 1441a through the containing structure S1, and then flow out of the cover 1441 from the opening end 1441b. In other words, the flow direction of the heat dissipation medium M is from the lower left (i.e., the upstream end) to the upper right (i.e., the downstream end) in FIG. 5. Nonetheless, the fluid-driving unit 1442 may also be designed to drive the heat dissipation medium M in a flow direction opposite to the flow direction indicated in FIG. 5, that is, flowing from the upper right to the lower left in FIG. 5, and the disclosure is not limited thereto.

In other words, in this embodiment, the fluid-driving unit 1442 drives the heat dissipation medium M in the same flow direction as that in the embodiments above, each flowing from the upstream end to the downstream end, with the fluid-driving unit 1442 of the embodiments above being disposed at the downstream end and the fluid-driving unit 1442 of this embodiment being disposed at the upstream end. Nonetheless, in this embodiment, the arrangement direction of the active heat dissipation module 140 does not affect its heat dissipation performance, and relatively effective cooling on the heating component 120 can be achieved.

In summary of the foregoing, in the immersion cooling device of the embodiment of the disclosure, the heat dissipation component is disposed on the heating component in the containing structure, and the cover covers the heat dissipation component, such that the heat dissipation component is located in the flow-guiding structure of the cover. Moreover, the cover is connected to the fluid-driving unit, which may drive the fluid to flow through the flow-guiding structure. Accordingly, it is possible to enhance the efficiency of the flow field in the containing structure, and particularly to increase the flow velocity and flow amount of the flow field around the heating component, effectively improving cooling on the heating component.

## Claims

1. An immersion cooling device (100) comprising:
a housing (105) comprising a tank (110) and at least one cover (1441), wherein the tank (110) has a containing structure (S1);
at least one heating component (120) located in the containing structure (S1), wherein the immersion cooling device (100) is adapted to cool the at least one heating component (120) in a single phase;
at least one heat dissipation component (142) disposed on the at least one heating component (120), wherein the at least one cover (1441) has a flow-guiding structure (S2) and covers the at least one heat dissipation component (142), such that the at least one heat dissipation component (142) is located in the flow-guiding structure (S2); and
at least one fluid-driving unit (1442) connected to the at least one cover (1441), wherein the flow-guiding structure (S2) communicates between the at least one fluid-driving unit (1442) and the containing structure (S1),
wherein the at least one cover (1441) comprises a top wall (1441c) and two sidewalls (1441d), and the two sidewalls (1441d) are respectively connected to two opposite edges (1441e) of the top wall (1441c).

2. The immersion cooling device (100) according to claim 1, comprising at least one circuit board (130), wherein the at least one heating component (120) is disposed on the at least one circuit board (130), and at least one of the at least one cover (1441) and the at least one heat dissipation component (142) is assembled on the at least one circuit board (130).

3. The immersion cooling device (100) according to claim 1, wherein the at least one cover (1441) is assembled on the at least one heat dissipation component (142).

4. The immersion cooling device (100) according to claim 1, wherein the at least one cover (1441) has a connecting end (1441a) and an opening end (1441b) opposite to each other, the connecting end (1441a) is connected to the at least one fluid-driving unit (1442), and the flow-guiding structure (S2) communicates with the containing structure (S1) through the opening end (1441b).

5. The immersion cooling device (100) according to claim 1, wherein the at least one cover (1441) has at least one tapered guide surface (1441f), and the at least one tapered guide surface (1441f) is located between the at least one fluid-driving unit (1442) and the at least one heat dissipation component (142).

6. The immersion cooling device (100) according to claim 1, wherein there is a gap (G) between the heat dissipation component (142) and the fluid-driving unit (1442).

7. An active heat dissipation module (140) comprising:
a heat dissipation component (142);
a cover (1441) having a flow-guiding structure (S2), wherein the cover (1441) covers the heat dissipation component (142), such that the heat dissipation component (142) is located in the flow-guiding structure (S2); and
a fluid-driving unit (1442) connected to the cover (1441), wherein the flow-guiding structure (S2) communicates with the fluid-driving unit (1442),
wherein the cover (1441) comprises a top wall (1441c) and two sidewalls (1441d), and the two sidewalls (1441d) are respectively connected to two opposite edges (1441e) of the top wall (1441c).

8. The active heat dissipation module (140) according to claim 7, wherein the cover (1441) is assembled on the heat dissipation component (142).

9. The active heat dissipation module (140) according to claim 7, wherein the cover (1441) has a connecting end (1441a) and an opening end (1441b) opposite to each other, and the connecting end (1441a) is connected to the fluid-driving unit (1442).

10. The active heat dissipation module (140) according to claim 7, wherein the cover (1441) has at least one tapered guide surface (1441f), and the at least one tapered guide surface (1441f) is located between the fluid-driving unit (1442) and the heat dissipation component (142).

11. The active heat dissipation module (140) according to claim 7, wherein there is a gap (G) between the heat dissipation component (142) and the fluid-driving unit (1442).

12. An active flow-guiding module (144) comprising:
a cover (1441) having a flow-guiding structure (S2); and
a fluid-driving unit (1442) connected to the cover (1441), wherein the flow-guiding structure (S2) communicates with the fluid-driving unit (1442),
wherein the cover (1441) comprises a top wall (1441c) and two sidewalls (1441d), and the two sidewalls (1441d) are respectively connected to two opposite edges (1441e) of the top wall (1441c).

13. The active flow-guiding module (144) according to claim 12, wherein the cover (1441) has a connecting end (1441a) and an opening end (1441b) opposite to each other, and the connecting end (1441a) is connected to the fluid-driving unit (1442).

14. The active flow-guiding module (144) according to claim 12, wherein the cover (1441) has at least one tapered guide surface (1441f), and the at least one tapered guide surface (1441f) is adjacent to the fluid-driving unit (1442).

15. The active flow-guiding module (144) according to claim 12, wherein there is a gap (G) between a heat dissipation component (142) and the fluid-driving unit (1442).

## Amended claims

### Amended claims in accordance with Rule 137(2) EPC.

1. An immersion cooling device (100) comprising:
a housing (105) comprising a tank (110) and at least one cover (1441), wherein the tank (110) has a containing structure (S1);
at least one heating component (120) located in the containing structure (S1), wherein the immersion cooling device (100) is adapted to cool the at least one heating component (120) in a single phase;
at least one heat dissipation component (142) disposed on the at least one heating component (120), wherein the at least one cover (1441) has a flow-guiding structure (S2) and covers the at least one heat dissipation component (142), such that the at least one heat dissipation component (142) is located in the flow-guiding structure (S2); and
at least one fluid-driving unit (1442) connected to the at least one cover (1441), wherein the flow-guiding structure (S2) communicates between the at least one fluid-driving unit (1442) and the containing structure (S1),
wherein the at least one cover (1441) comprises a top wall (1441c) and two sidewalls (1441d), and the two sidewalls (1441d) are respectively connected to two opposite edges (1441e) of the top wall (1441c),
wherein the immersion cooling device (100) is **characterized in that**
the at least one cover (1441) has at least one tapered guide surface (1441f), and the at least one tapered guide surface (1441f) is located between the at least one fluid-driving unit (1442) and the at least one heat dissipation component (142).

2. The immersion cooling device (100) according to claim 1, comprising at least one circuit board (130), wherein the at least one heating component (120) is disposed on the at least one circuit board (130), and at least one of the at least one cover (1441) and the at least one heat dissipation component (142) is assembled on the at least one circuit board (130).

3. The immersion cooling device (100) according to claim 1, wherein the at least one cover (1441) is assembled on the at least one heat dissipation component (142).

4. The immersion cooling device (100) according to claim 1, wherein the at least one cover (1441) has a connecting end (1441a) and an opening end (1441b) opposite to each other, the connecting end (1441a) is connected to the at least one fluid-driving unit (1442), and the flow-guiding structure (S2) communicates with the containing structure (S1) through the opening end (1441b).

5. The immersion cooling device (100) according to claim 1, wherein there is a gap (G) between the heat dissipation component (142) and the fluid-driving unit (1442).

6. An active heat dissipation module (140) applied in the immersion cooling device (100) according to any one of claims 1 to 5.

7. An active flow-guiding module (144) applied in the immersion cooling device (100) according to any one of claims 1 to 5.
